Europäisches Patentamt

European Patent Office

Office européen des brevets

(11) Veröffentlichungsnummer: **0 441 429 A2**

## (12) EUROPÄISCHE PATENTANMELDUNG

(21) Anmeldenummer: 91200183.1

(22) Anmeldetag: 30.01.91

(51) Int. Cl.5: **C30B 15/00, C30B 29/22**

(30) Priorität: 03.02.90 DE 4003184

(43) Veröffentlichungstag der Anmeldung:
**14.08.91 Patentblatt 91/33**

(84) Benannte Vertragsstaaten:
**DE FR GB IT**

(71) Anmelder: **Philips Patentverwaltung GmbH**
**Wendenstrasse 35 Postfach 10 51 49**
**W-2000 Hamburg 1(DE)**

(84) **DE**

Anmelder: **N.V. Philips' Gloeilampenfabrieken**
**Groenewoudseweg 1**

**NL-5621 BA Eindhoven(NL)**

(84) **FR GB IT**

(72) Erfinder: **Mateika, Dieter, Dr.**
**Seerosenstrasse 16**
**W-2087 Ellerbek(DE)**
Erfinder: **Völkel, Erich, Dipl.-Ing.**
**Wiesingerweg 34**
**W-2000 Hamburg 20(DE)**

(74) Vertreter: **Nehmzow-David, Fritzi-Maria et al**
**Philips Patentverwaltung GmbH**
**Wendenstrasse 35 Postfach 10 51 49**
**W-2000 Hamburg 1(DE)**

(54) **Verfahren zur Züchtung von Mischkristallen aus Schmelzen oxidischer Vielstoffsysteme.**

(57) Verfahren zur Züchtung von Mischkristallen mit zwei Gitterplätzen mit jeweils einer unterschiedlichen Anzahl benachbarter Sauerstoffionen aus Schmelzen oxidischer Vielstoffsysteme, wobei homogene Mischkristalle gezüchtet werden derart, daß die Kationen für die Besetzung des ersten Gitterplatzes mit der höchsten Anzahl benachbarter Sauerstoffionen und für die Besetzung des zweiten Gitterplatzes mit der nächst niedrigeren Anzahl benachbarter Sauerstoffionen so ausgewählt werden, daß das Verhältnis der mittleren Ionenradien der Kationen auf dem ersten Gitterplatz zu den mittleren Ionenradien der Kationen auf dem zweiten Gitterplatz im Bereich von 2,2 bis 2,5 liegt.

FIG.2

EP 0 441 429 A2

## VERFAHREN ZUR ZÜCHTUNG VON MISCHKRISTALLEN AUS SCHMELZEN OXIDISCHER VIELSTOFFSYSTEME

Die Erfindung betrifft ein Verfahren zur Züchtung von Mischkristallen mit zwei Gitterplätzen mit jeweils einer unterschiedlichen Anzahl benachbarter Sauerstoffionen aus Schmelzen oxidischer Vielstoffsysteme sowie die Anwendung der nach diesem Verfahren hergestellten Mischkristalle.

Um homogene Kristalle zu erhalten, muß die Bedingung erfüllt sein, daß der Verteilungskoeffizient der Kationen $k_{eff(kat)}$, also das Verhältnis der Konzentration der Kationen in der Solidusphase zur Kontration der Kationen in der Liquidusphase $C_s/Cl$ etwa bei 1 liegt. Hierbei ist zu beachten, daß aufgrund der Analysenfehler bei der Bestimmung der chemischen Zusammensetzung bei kleinen Konzentrationen der Kationen auch noch Verteilungskoeffizienten im Bereich von 0,90 bis 1,20 zu dem Bereich von "etwa bei 1" gezählt werden können.

Unter Kristallen ist sowohl monokristallines als auch polykristallines Material zu verstehen.

Scheiben von aus Schmelzen oxidischer Vielstoffsysteme gezogenen Einkristallen finden beispielsweise als Epitaxiesubstrate Verwendung. Um einwandfreie einkristalline Schichten auf einkristallinen Substraten züchten zu können, ist es erforderlich, daß die Gitterkonstanten von Substrat und epitaxialer Schicht möglichst übereinstimmen. Z.B. werden für die Herstellung von einkristallinen supraleitenden Schichten aus z.B. $YBa_2Cu_3O_7-_\delta$ mit den Gitterkonstanten a = 0,3818 nm, b = 0,3886 nm und c = 1,1680 nm einkristalline Substrate aus z.B $SrTiO_3$ (a = 0,3909 nm), $LaAlO_3$ (a = 0,3792 nm) oder $LaGaO_3$ (a = 0,3877 nm, b = 0,3903 nm und c = 0,5481 nm) benutzt. Wie ersichtlich, weichen die Gitterkonstanten aller drei genannten Substrate deutlich ab von den Gitterkonstanten der genannten supraleitenden Schicht.

Hinzu kommt, daß sich in den $LaGaO_3$- und $LaAlO_3$-Kristallen während der Abkühlphase Mikrozwillinge bilden, die die Kristallqualität der Substrate erheblich verschlechtern. Solche Substrate sind daher für die Herstellung von einkristallinen Schichten des genannten Supraleiters nicht geeignet. Es muß also ein Weg gefunden werden, der die Herstellung von Einkristallen mit gewünschten Gitterkonstanten auf möglichst einfache Weise erlaubt.

Als Ausweg bietet sich für die Herstellung von Substraten mit gewünschten Gitterkonstanten die Züchtung von homogenen Mischkristallen an, bei denen die Gitterkonstante über die Kristallzusammensetzung eingestellt wird. Hierbei muß jedoch beachtet werden, daß die Verteilungskoeffizienten der Kationen $k_{eff(kat)}$ im Bereich um 1 liegen, denn nur in diesem Fall werden homogene Mischkristalle, also Mischkristalle, die über die gesamte Länge des gezogenen Kristalls eine etwa gleiche Gitterkonstante haben, erhalten. Mischkristalle können durch Mischen zweier Endglieder einer Mischkristallreihe hergestellt werden; derartige Mischkristalle haben jedoch Verteilungskoeffizienten, die relativ weit von 1 abweichen. Wegen der daraus resultierenden geringen Kristallqualität und der Änderung der Gitterkonstante in Längsrichtung des Kristalls sind Mischkristalle, die durch Mischen zweier Endglieder hergestellt werden, im allgemeinen für technische Anwendungen nicht zu gebrauchen.

Ein Ausweg könnte die Anwendung von Vielstoffsystemen unter Züchtung von homogenen Mischkristallen aus deren Schmelzzusammensetzungen sein, die wegen ihrer größeren Anzahl von Kationen mehr Möglichkeiten bieten, die Verteilungskoeffizienten über die Zusammensetzung zu optimieren. Systematische Wege hierzu sind jedoch erst ansatzweise vorgeschlagen worden.

Um systematisch Mischkristall-Schmelzsysteme erstellen zu können, in denen die Verteilungskoeffizienten aller Kationen nahe bei 1 liegen, ist mit der deutschen Patentanmeldung P 39 04 868.3 vorgeschlagen worden, die mittleren Bindungslängen Kation/Sauerstoff, also Strukturdaten, für die Definition solcher Vielstoffsysteme zu benutzen, weil erkannt worden war, daß diese Strukturdaten in unmittelbarem Zusammenhang mit der Kristallzusammensetzung stehen. Die mittleren Bindungslängen Kation/Sauerstoff lassen sich für Mischkristalle mit Granat-, Perowskit- oder Spinellgitter nach Formeln berechnen, die empirisch für diese Gitter ermittelt wurden und aus der Fachliteratur bekannt sind.

Der Erfindung liegt die Aufgabe zugrunde, ein Verfahren anzugeben, mit dem systematisch Zusammensetzungen oxidischer Vielstoffsysteme zur Herstellung von Mischkristallen mit zwei Gitterplätzen mit jeweils einer unterschiedlichen Anzahl benachbarter Sauerstoffionen gefunden werden können, die geeignet sind für die Herstellung von Schmelzen zur Züchtung von Mischkristallen mit Verteilungskoeffizienten etwa bei 1, wenn Formeln zur Berechnung der mittleren Bindungslänge Kation/Sauerstoff nicht zur Verfügung stehen.

Diese Aufgabe wird erfindungsgemäß dadurch gelöst, daß homogene Mischkristalle gezüchtet werden, derart, daß die Kationen für die Besetzung des ersten Gitterplatzes mit der höchsten Anzahl benachbarter Sauerstoffionen und für die Besetzung des zweiten Gitterplatzes mit der nächst niedrigeren Anzahl benachbarter Sauerstoffionen so ausgewählt werden, daß das Verhältnis der mittleren Ionenradien der Kationen auf dem ersten Gitterplatz zu den mittleren Ionenradien der Kationen auf dem zweiten Gitterplatz

2

im Bereich von 2,2 bis 2,5 liegt.

Es hat sich gezeigt, daß auch die mit einem bestimmten Verhältnis der Ionenradien der Kationen auf benachbarten Gitterplätzen gegebenen Strukturdaten dazu dienen können, systematisch Zusammensetzungen zu ermitteln für Schmelzen oxidischer Vielstoffsysteme, aus denen Mischkristalle mit Verteilungskoeffizienten etwa bei 1 gezüchtet werden können.

Nach einer vorteilhaften Weiterbildung des Verfahrens gemäß der Erfindung werden die Kationen für die Besetzung des ersten Gitterplatzes und für die Besetzung des zweiten Gitterplatzes so ausgewählt, daß das Verhältnis der mittleren Ionenradien der Kationen auf dem ersten Gitterplatz zu den mittleren Ionenradien der Kationen auf dem zweiten Gitterplatz im Bereich von 2,23 bis 2,46 liegt.

Nach einer weiteren vorteilhaften Ausgestaltung des erfindungsgemäßen Verfahrens wird die Zusammensetzung der die Schmelze bildenden Komponenten zur Züchtung homogener Mischkristalle in Abhängigkeit jeweils der mittleren Ionenradien der Kationen des Kubooktaederplatzes (Koordinationszahl = 12) und der Kationen des Oktaederplatzes (Koordinationszahl = 6) so ausgewählt, daß die mittleren Ionenradien der Kationen des Kubooktaederplatzes im Bereich von 0,14168 nm bis 0,12842 nm und die mittleren Ionenradien der Kationen des Oktaederplatzes im Bereich von 0,05648 nm bis 0,05865 nm liegen.

Nach einer weiteren vorteilhaften Ausgestaltung des Verfahrens gemäß der Erfindung werden Mischkristalle gezüchtet mit einer Zusammensetzung gemäß der allgemeinen Formel $RE_wA_xAl_yB_zO_3$ worin sind

$RE$ = 1 Kation aus der Gruppe $La^{3+}$, $Pr^{3+}$, $Ce^{3+}$, $Nd^{3+}$, $Sm^{3+}$, $Eu^{3+}$, $Gd^{3+}$, $Tb^{3+}$, $Dy^{3+}$, $Ho^{3+}$, $Y^{3+}$,

$A$ = $Ca^{2+}$ und/oder $Sr^{2+}$

$B$ = $Ta^{5+}$ und/oder $Nb^{5+}$ und $0,030 \leq w \leq 0,490$

$0,510 \leq x \leq 0,960$

$0,530 \leq y \leq 0,745$

$0,255 \leq z \leq 0,480$

Die nach dem erfindungsgemäßen Verfahren hergestellten Mischkristalle können immer dann mit Vorteil verwendet werden, wenn es gilt, Kristalle mit zwei unterschiedlichen Gitterplätzen mit bestimmten gewünschten Eigenschaften herzustellen. Die nach dem Verfahren gemäß der Erfindung hergestellten Mischkristalle sind beispielsweise geeignet für die Herstellung monokristalliner Schichten auf Substraten, wobei die Gitterkonstante der abzuscheidenden Schicht über ihre Zusammensetzung innerhalb relativ weiter Grenzen an die Gitterkonstante des Substrates angepaßt werden kann. Monokristalline Schichten sind z.B. epitaxiale Schichten, die nach bekannten Verfahren, wie z.B. Flüssigphasenepitaxie oder Gasphasenepitaxie oder durch einen Kathodenzerstäubungsprozeß mit anschließender Temperung, hergestellt werden. Monomolekulare epitaxiale Schichten können durch "atomic layer epitaxy" hergestellt werden. Die nach dem erfindungsgemäßen Verfahren hergestellten Mischkristalle können auch mit Vorteil für die Herstellung von auf einem Substrat angebrachten Vielschichtstrukturen aus unterschiedlichen monokristallinen Schichten einer Dicke von jeweils > 100 x a oder < 100 x a verwendet werden, wobei a die Gitterkonstante des Materials der jeweiligen Schicht ist.

Mit Vielschichtstrukturen aus unterschiedlichen monokristallinen Schichten einer Dicke von jeweils > 100 x a können z.B. Superstrukturen aufgebaut werden;
Superstrukturen sind Vielschichtstrukturen mit Einzelschichten unterschiedlicher Eigenschaften.

Mit Vielschichtstrukturen aus unterschiedlichen monokristallinen Schichten einer Dicke von jeweils < 100 x a können auch z.B. Supergitter aufgebaut werden. Supergitter sind Vielschichtstrukturen mit Einzelschichten sehr geringer Schichtdicke (jedoch größer als monomolekular), in denen die intrinsischen Eigenschaften des "bulk-Materials" entsprechender Zusammensetzung, also eines Einkristalls mit größeren Abmessungen (> 100 x a), noch nicht ausgebildet sind.

Es können aber auch einkristalline Substrate zur Abscheidung von einkristallinen Schichten mit an die Gitterkonstanten der abzuscheidenden Schichten relativ genau angepaßten Gitterkonstanten aus den nach dem vorliegenden Verfahren hergestellten Mischkristallen hergestellt werden. Dies hat eine besondere Bedeutung für die Weiterentwicklung von Bauelementen mit noch am Anfang ihrer technologischen Anwendung stehenden Supraleiterschichten.

Im folgenden werden Ausführungsbeispiele der Erfindung beschrieben und in ihrer Wirkungsweise erläutert.

Die Figuren zeigen:

Figur 1     Strukturmodell kubischer Perowskite;

Figur 2     Beziehung der mittleren Ionenradien der Kationen auf dem Kubooktaederplatz zu den mittleren Ionenradien der Kationen auf dem Oktaederplatz für Mischkristalle mit Zusammensetzung gemäß der allgemeinen Formel $RE_wA_xAl_yTa_zO_3$;

Figur 3     schematische Darstellung zur Anpassung der zweiten Gitterkonstanten b' in Abhängigkeit vom Winkel zwischen der kristallographischen b-Achse und einer angenommenen b'-Achse für die Anwendung der Mischkristalle als Substrate für Hochtemperatursupraleiter-Schichten.

Die systematische Herstellung von homogenen Mischkristallen mit zwei Gitterplätzen mit jeweils einer unterschiedlichen Anzahl benachbarter Sauerstoffionen mit einem Verteilungskoeffizienten etwa bei 1 aus Schmelzen oxidischer Vielstoffsysteme wird am Beispiel von Seltenerdmetall/Aluminium-Perowskiten als Wirtsgitter verdeutlicht.

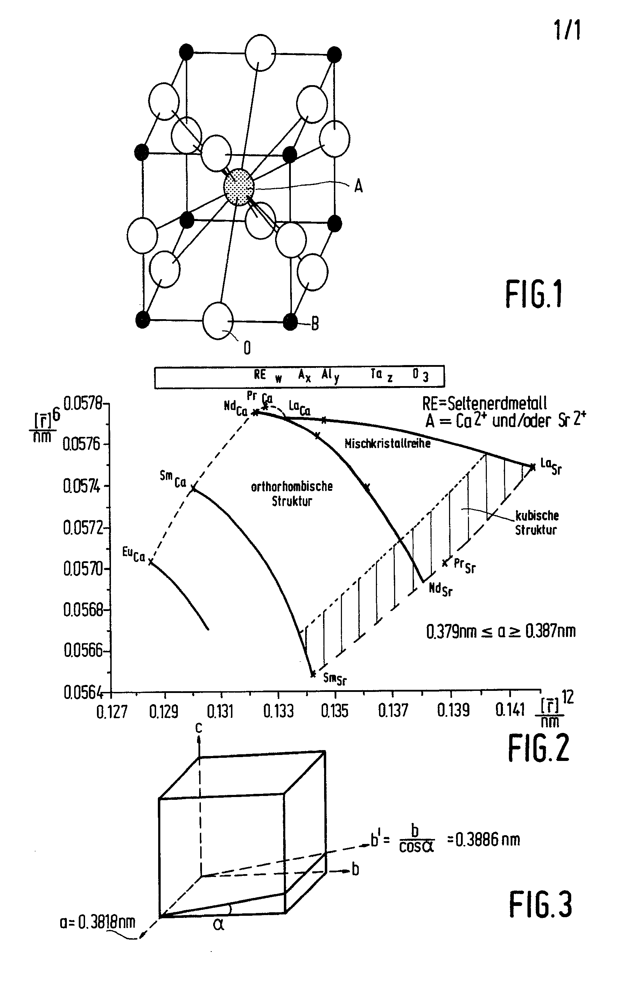

In Figur 1 ist das Strukturmodell kubischer Perowskite dargestellt. Perowskite werden durch die allgemeine Formel $ABO_3$ beschrieben. Das A-Kation in der Zellmitte ist kubooktaedrisch von 12 Sauerstoffionen umgeben. Die B-Kationen in den Zellecken sind oktaedrisch von 6 Sauerstoffionen umgeben. Im Wirtsgitter sind die A-Plätze von Seltenerdmetall und die B-Plätze von $Al^{3+}$-Kationen besetzt. Bei den Mischkristallen werden die Seltenerdmetalle teilweise durch $Ca^{2+}$- und/oder durch $Sr^{2+}$-Kationen und die $Al^{3+}$-Kationen teilweise durch $Ta^{5+}$- und/oder $Nb^{5+}$-Kationen substituiert. Nur jeweils drei Sauerstoffionen der B-Kationen werden im Strukturausschnitt der Figur 1 gezeigt.

In Figur 2 ist die Beziehung der mittleren Ionenradien der Kationen auf dem Kubooktaederplatz zu den mittleren Ionenradien der Kationen auf dem Oktaederplatz für Mischkristalle mit der Zusammensetzung gemäß der allgemeinen Formel $RE_wA_xAl_yTa_zO_3$ mit RE = $Eu^{3+}$, $Sm^{3+}$, $Nd^{3+}$, $Pr^{3+}$, $La^{3+}$, mit A = $Ca^{2+}$ und/oder $Sr^{2+}$

und mit $0,219 \leq w \leq = 0,490$; $0,510 \leq x \leq 0,772$ $0,615 \leq y \leq 0,745$; $0,255 \leq z \leq 0,391$ dargestellt. Die Gitterkonstanten in der kristallographischen a-Richtung können im Bereich von 0,379 bis 0,387 nm über die Kristallzusammensetzung eingestellt werden.

Die Kristallzusammensetzung der Perowskite wird durch die allgemeine Formel $ABO_3$ wiedergegeben. Zu den A-Kationen gehören im wesentlichen folgende Ionen: $Na^{1+}$, $K^{1+}$,
$Ca^{2+}$, $Sr^{2+}$, $Ba^{2+}$, $Pb^{2+}$, $Y^{3+}$, $Ce^{3+}$, $Nd^{3+}$,
$Sm^{3+}$, $Eu^{3+}$, $Gd^{3+}$, $Tb^{3+}$, $Dy^{3+}$, $Ho^{3+}$, $Er^{3+}$,
$La^{3+}$, $Th^{4+}$, $Ce^{4+}$, Die B-Position wird im wesentlichen durch folgende Kationen besetzt: $Li^{1+}$,
$Mg^{2+}$, $Zn^{2+}$, $Cu^{2+}$, $Co^{2+}$, $Fe^{2+}$, $Mn^{2+}$, $Ni^{2+}$,
$Al^{3+}$, $Ga^{3+}$, $Sc^{3+}$, $In^{3+}$, $Yb^{3+}$, $Lu^{3+}$, $Mn^{3+}$,
$Fe^{3+}$, $Co^{3+}$, $Cr^{3+}$, $Ni^{3+}$, $Cu^{3+}$, $Ge^{4+}$, $Hf^{4+}$,
$Ce^{4+}$, $Sn^{4+}$, $Cr^{4+}$, $Ti^{4+}$, $Mn^{4+}$, $Ta^{5+}$, $Nb^{5+}$,
$V^{5+}$, $Mo^{5+}$, $W^{5+}$, $Mo^{6+}$, $W^{6+}$.

Einige Ionenradien dieser Kationen in Abhängigkeit von der Sauerstoff-Koordinationszahl sind in der nachfolgenden Tabelle 1 aufgelistet. In einfach zusammengesetzten Perowskiten sind die A-Plätze mit einem großen und die B-Plätze mit einem kleinen Kation besetzt wie z.B. in der Verbindung $LaAlO_3$, wo die $La^{3+}$-Ionen die A-Plätze besetzen und die $Al^{3+}$-Ionen die B-Plätze ausfüllen. Solche einfach zusammengesetzte Perowskite werden im folgenden als Wirtsgitter verwendet.

Die Kationen der Wirtsgitter (Seltenerdmetall/Aluminium) werden teilweise durch die Kationen $Sr^{2+}$, $Ca^{2+}$, $Ta^{5+}$ bzw. $Nb^{5+}$ ersetzt. Für die Mischkristalle werden nur diejenigen Zusammensetzungen ausgewählt, bei denen das Verhältnis der mittleren Ionenradien der Kationen auf dem ersten Gitterplatz zu den mittleren Ionenradien der Kationen auf dem zweiten Gitterplatz im Bereich von 2,2 bis 2,5 liegt.

Oxidmischungen solcher Zusammensetzungen werden in einem Iridiumtiegel unter schwach oxidierender Atmosphäre aufgeschmolzen. Anschließend wird ein Iridiumstab in die Schmelze getaucht und die Temperatur der Schmelze solange erniedrigt, bis sich um den Iridiumstab herum ein Kristallisat bildet. Das Kristallisat wird mit einer Geschwindigkeit von 5 mm/h von der Schmelzoberfläche nach oben abgezogen. Der Wachstumsvorgang wird unterbrochen, wenn die Hälfte der Ausgangsschmelze kristallisiert ist. Nach dem Abkühlen auf Raumtemperatur wird das Kristallisat auf seine Zusammensetzung hin analysiert. Ist die Konzentration der Substituenten (hier $Sr^{2+}$ und $Ta^{5+}$) im Kristallisat kleiner als in der Ausgangsschmelze, sind die Verteilungskoeffizienten $k_{eff} = C_{kat\ Kristall}/C_{kat\ Schmelze}$ von $Sr^{2+}$ und $Ta^{5+}$ < 1.

In diesem Fall wird das Verfahren mit einer höheren Konzentration der Substituenten wiederholt. Da die Verteilungskoeffizienten mit steigender Konzentration der Substituenten ansteigen, sind im zweiten Verfahrensschritt höhere Werte für die Verteilungskoeffizienten zu erwarten. Die Versuchsreihe mit ansteigender Konzentration der Substituenten wird solange fortgesetzt, bis die Konzentration der Substituenten im Kristallisat gleich der Konzentration der Substituenten in der Schmelze ist ($k_{eff\ (kat)} \approx 1$). Von den Zusammensetzungen mit $k_{eff\ (kat)} \approx 1$ werden Einkristalle gezüchtet.

Zur Herstellung von Einkristallen werden die Oxide entsprechend den Ergebnissen der Vorversuche gemischt, in Zylinderform verpreßt und bei einer Temperatur von 1500 °C in Sauerstoffatmosphäre gesintert.

Für beispielsweise einen Einkristall der Zusammensetzung $La_{0,29}Sr_{0,71}Al_{0,645}Ta_{0,355}O_3$ werden 30,5281

g $^{LA}2O_3$; 47,5396 g SrO; 21,2481 g $Al_2O_3$ und 50,6841 g $^{Ta}2O_5$ (Gesamteinwaage 150,00 g) gemischt und wie oben beschrieben weiterbehandelt. Der Sinterkörper wird anschließend in einem Iridiumtiegel eines Durchmessers von 40 mm und einer Höhe von 40 mm bei einer Temperatur von etwa 2000 °c in einer geschlossenen Kristallziehapparatur aufgeschmolzen. Durch die Apparatur wird Inertgas wie Stickstoff oder ein Gasgemisch aus 90 % N2 + 10% $CO_2$ geleitet. Als Impfkristall dient ein zylinderförmiger Einkristallstab gleicher Zusammensetzung (aus den Vorversuchen) mit der kristallographischen [100]-Richtung parallel zur Stabachse. Der Impfkristall wird zunächst in die Schmelze eingetaucht (Animpfen) und anschließend mit einer Geschwindigkeit von 5 mm/h von der Schmelzoberfläche nach oben abgezogen. Der wachsende Kristall wird mit einer beschleunigenden und verzögernden Rotation (z.B. 25 min$^{-1}$ → 75 min$^{-1}$ in zwei Sekunden und 75 min$^{-1}$ → 25 min$^{-1}$ in einer Sekunde) um seine Achse gedreht. Der Wachstumsprozeß wird über eine Gewichtsregelung in der Weise gesteuert, daß der Kristall zunächst konusförmig in die Breite wächst, bis der gewünschte Kristalldurchmesser erreicht ist. Anschließend wird die Leistung des Generators so geregelt, daß der Kristall mit konstantem Durchmesser weiterwächst. Der Wachstumsprozeß wird beendet durch schnelles Abziehen des gewachsenen Kristalls von seiner Restschmelze. Anschließend wird der Kristall langsam auf Raumtemperatur abgekühlt.

Für die Bestimmung der Kristallzusammensetzung und der Gitterkonstanten werden Scheiben vom Kristallanfang und Kristallende abgeschnitten, wobei zur Bestimmung der Kristallzusammensetzung die Röntgenfluoreszenzanalyse (Analysenfehler: ± 0,01 Formeleinheiten) eingesetzt wird.

Im folgenden wird die Herstellung von Mischkristallen aus zwei Mischkristallgruppen mit mehreren Mischkristallreihen beschrieben.

### 1. Tantalgruppe

Es werden Mischkristalle einer Zusammensetzung gemäß der allgemeinen Formel $RE_wA_xAl_yTa_zO_3$ mit $RE = Eu^{3+}$,
$Sm^{3+}$, $Nd^{3+}$, $Pr^{3+}$, $La^{3+}$, mit $A = Ca^{2+}$ und/oder $Sr^{2+}$ und mit
$0,219 \leq w \leq 0,490$; $0,510 \leq x \leq 0,772$;
$0,615 \leq y \leq 0,745$; $0,255 \leq z \leq 0,391$.

Als Parameter für die Definition der nachstehend genannten 5 Mischkristallreihen der Tantalgruppe dienen die mittleren Ionenradien der Kationen des Kubooktaeder- und des Oktaederplatzes.

Die mittleren Ionenradien der Kationen von Kristallzusammensetzungen mit einem Verteilungskoeffizienten $k_{eff\ (kat)} \approx 1$ sind mit den Kurven im Diagramm gemäß der Figur 2 dargestellt. Die mittleren Ionenradien der Kristallzusammensetzungen mit $Ca^{2+}$ bzw. $Sr^{2+}$ bilden die Anfangs- bzw. Endglieder der Mischkristallreihen (gestrichelte Kurven). Der Ca-Gehalt der Anfangsglieder kann sukzessiv durch $Sr^{2+}$-Kationen substituiert werden, bis die Zusammensetzung des nur noch $Sr^{2+}$ enthaltenden Endgliedes erhalten wird. Die Änderung der mittleren Ionenradien für die Mischkristallzusammensetzungen mit $Ca^{2+}$ und $Sr^{2+}$ als Gastionen werden durch die Kurven mit den durchgezogenen Linien (Figur 2) beschrieben. Die Kristallzusammensetzungen mit $Sr^{2+}$ sowie diejenigen mit $Sr^{2+}$ und wenig $Ca^{2+}$ haben eine kubische Kristallstruktur. Alle anderen Zusammensetzungen besitzen eine orthorombische Kristallstruktur. Jede Kurve in Figur 2 gehört zu einer bestimmten Mischkristallreihe der Tantalgruppe.

Für alle Mischkristallzusammensetzungen mit mittleren Ionenradien entsprechend dem Verlauf der Kurven gemäß Figur 2 liegen die Verteilungskoeffizienten etwa bei 1.

Die Zusammensetzungen der Mischkristallreihen sind wie folgt definiert:

1. $La_wCa_xSr_vAl_yTa_zO_3$
(entsprechend La-Kurve in Figur 2).

Das Anfangsglied der Mischkristallreihe wird beschrieben durch die Formel
$La_{0,221}Ca_{0,763}Al_{0,622}Ta_{0,389}O_3$, worin die mittleren Ionenradien der Kationen für den Kubooktaederplatz und den Oktaederplatz betragen:
$[\bar{r}]12 = 0,13311$ nm, $[\bar{r}]^6 = 0,05772$ nm.

Das Endglied der Mischkristallreihe wird beschrieben durch die Formel $La_{0,290}Sr_{0,710}Al_{0,645}Ta_{0,355}O_3$, worin die mittleren Ionenradien der Kationen für den Kubooktaederplatz und den Oktaederplatz betragen:
$[\bar{r}]12 = 0,14168$ nm, $[\bar{r}]^6 = 0,05749$ nm.

Die Mischkristallzusammensetzungen liegen im folgenden Bereich:
$0,221 \leq La \leq 0,290$; $0 \leq Ca \leq 0,763$; $0 \leq Sr \leq 0,710$;
$0,622 \leq Al \leq 0,645$; $0,355 \leq Ta \leq 0,389$.

Es wird jeweils die Schmelzzusammensetzung angegeben. Dies gilt auch für alle folgenden Ausfüh-

rungsbeispiele.

2. $Pr_wCa_xSr_vAl_yTa_zO_3$.

Das Anfangsglied der Mischkristallreihe wird beschrieben durch die Formel $Pr_{0,219}Ca_{0,772}Al_{0,615}Ta_{0,391}O_3$, worin die mittleren Ionenradien der Kationen für den Kubooktaederplatz und den Oktaederplatz betragen: $[\bar{r}]12 = 1,3236$ nm; $[\bar{r}]^6 = 0,05778$ nm.

Das Endglied der Mischkristallreihe wird beschrieben durch die Formel $Pr_{0,38}Sr_{0,62}Al_{0,69}Ta_{0,31}O_3$, worin die mittleren Ionenradien für die Kationen auf dem Kubooktaederplatz und dem Oktaederplatz betragen: $[\bar{r}]12 = 0,13868$ nm, $[\bar{r}]^6 = 0,05703$ nm.

Die Mischkristallzusammensetzungen liegen in folgendem Bereich:

$0,219 \leq Pr \leq 0,38$; $0 \leq Ca \leq 0,772$; $0 \leq Sr \leq 0,62$;

$0,615 \leq Al \leq 0,69$; $0,31 \leq Ta \leq 0,391$.

3. $Nd_wCa_xSr_vAl_yTa_zO_3$
(Nd-Kurve in Figur 2).

Das Anfangsglied der Mischkristallreihe wird beschrieben durch die Formel: $Nd_{0,225}Ca_{0,766}Al_{0,619}Ta_{0,387}O_3$, worin die mittleren Ionenradien für die Kationen auf dem Kubooktaederplatz und dem Oktaederplatz betragen: $[\bar{r}]12 = 0,13211$ nm, $[\bar{r}]^6 = 0,05775$ nm.

Das Endglied der Mischkristallreihe wird beschrieben durch die Formel: $Nd_{0,40}Sr_{0,60}Al_{0,70}Ta_{0,30}O_3$, worin die mittleren Ionenradien für die Kationen auf dem Kubooktaederplatz und dem Oktaederplatz betragen: $[\bar{r}]12 = 0,138$ nm, $[\bar{r}]^6 = 0,05693$ nm.

Die Mischkristallzusammensetzungen liegen in folgendem Bereich:

$0,225 \leq Nd \leq 0,40$; $0 \leq Ca \leq 0,766$; $0 \leq Sr \leq 0,60$;

$0,619 \leq Al \leq 0,700$; $0,300 \leq Ta \leq 0,387$.

4. $Sm_wCa_xSr_vAl_yTa_zO_3$
(Sm-Kurve in Figur 2).

Das Anfangsglied der Mischkristallreihe wird beschrieben durch die Formel $Sm_{0,288}Ca_{0,697}Al_{0,654}Ta_{0,356}O_3$, worin die mittleren Ionenradien für die Kationen auf dem Kubooktaederplatz und dem Oktaederplatz betragen: $[\bar{r}]12 = 0,12985$ nm, $[\bar{r}]^6 = 0,05739$ nm.

Das Endglied der Mischkristallreihe wird beschrieben durch die Formel: $Sm_{0,49}Sr_{0,51}Al_{0,745}Ta_{0,255}O_3$, worin die mittleren Ionenradien für die Kationen auf Kubooktaederplatz und dem Oktaederplatz betragen: $[\bar{r}]12 = 0,1342$ nm, $[\bar{r}]^6 = 0,05648$ nm.

Die Mischkristallzusammensetzungen liegen in folgendem Bereich:

$0,288 \leq Sm \leq 0,49$; $0 \leq Ca \leq 0,697$; $0 \leq Sr \leq 0,51$;

$0,654 \leq Al \leq 0,745$; $0,255 \leq Ta \leq 0,356$.

5. $Eu_wCa_xSr_vAl_yTa_zO_3$
(Eu = Kurve in Figur 2).

Das Anfangsglied der Mischkristallreihe wird beschrieben durch die Formel: $Eu_{0,356}Ca_{0,626}Al_{0,69}Ta_{0,322}O_3$, worin die mittleren Ionenradien für die Kationen auf dem Kubooktaederplatz und dem Oktaederplatz betragen: $[\bar{r}]12 = 0,12842$ nm, $[\bar{r}]^6 = 0,05703$ nm.

Das Endglied der Mischkristallreihe wird beschrieben durch die Formel: $Eu_{0,43}Ca_{0,315}Sr_{0,243}Al_{0,723}Ta_{0,285}O_3$, worin die mittleren Ionenradien für die Kationen auf dem Kubooktaederplatz und dem Oktaederplatz betragen: $[\bar{r}]12 = 0,13051$ nm, $[\bar{r}]^6 = 0,05670$ nm.

Die Mischkristallzusammensetzungen liegen in folgendem Bereich:

$0,356 \leq Eu \leq 0,43$; $0,315 \leq Ca \leq 0,626$; $0 \leq Sr \leq 0,243$;

$0,69 \leq Al \leq 0,723$; $0,285 \leq Ta \leq 0,322$.

Die Grenzen der Mischkristallbildung in der Tantal-Gruppe sind erreicht, wenn die Funktionswerte der Kurven gemäß Figur 2 durch Bildung von Fremdphasen nicht mehr eingehalten werden können.

Die Mischkristallbildung erfolgt durch die gekoppelte Substitution der Seltenerdmetall- und Aluminium-Kationen durch Erdalkali- und Tantal-Kationen nach folgendem Schema: $2La^{3+} + Al^{3+} \rightarrow 2Ca^{2+} + Ta^{5+}$. Nach den Analysenergebnissen ist bei den Ca-haltigen Mischkristallen die Summe der Kationen auf dem Kubooktaederplatz (z.B. $La^{3+} + Ca^{2+}$) < 1, während die Summe der Kationen auf dem Oktaederplatz (z.B. $Al^{3+} + Ta^{5+}$) > 1 ist. Zur Deutung dieses Ergebnisses wird angenommen, daß kleine Konzentrationen von Tantal auch den Kubooktaederplatz besetzen. Gleichzeitig werden auf dem A-Platz Kationenleerstellen gebildet entsprechend dem Schema $RE^{3+} + Ca^{2+} \rightarrow Ta^{5+}$ + Leerstelle. Die Ta-Konzentration variiert im Bereich von 0,02 bis < 0,005 Formeleinheiten. Sie steigt mit abnehmenden Radien der Seltenerdmetalle an. Für Tantal auf dem A-Platz wird (nach Shannon a.a.O.) ein Radius von 0,074 nm angenommen.

In der Tantal-Gruppe können die Gitterkonstanten in der kristallograpischen a-Richtung normiert auf die Einheitszelle über die Kristallzusammensetzung im Bereich von 0,379 nm bis 0,387 nm eingestellt werden (vergleiche Figur 2 und Tabelle 2).

Aus Schmelzen der beschriebenen Mischkristallsysteme wurden Einkristalle nach dem Czochralski-Verfahren hergestellt. Die Werte jeweils für die Schmelz- und Kristallzusammensetzung, die mittleren Ionenradien, die Verteilungskoeffizienten $k_{eff(kat)}$, die Gitterkonstanten, die Bindungslängen für kubische Perowskite sowie die auf die Einheitszelle normierten Gitterkonstanten ergeben sich aus der Tabelle 2. Die gezüchteten Kristalle haben einen Durchmesser von 15 mm und Kristallängen von 50 mm.

## 2. Niob-Gruppe

Es wurden Mischkristalle mit einer Zusammensetzung gemäß der allgemeinen Formel:
$Re_wA_xAl_y Nb_zO_3$ mit RE = $y^{3+}$, $Ho^{3+}$, $Dy^{3+}$,
$Tb^{3+}$, $Gd^{3+}$, $Sm^{3+}$, $Nd^{3+}$, $Pr^{3+}$, $La^{3+}$, mit A = $Ca^{2+}$ und/oder $Sr^{2+}$ und mit
$0,030 \leq w \leq 0,320$; $0,680 \leq x \leq 0,960$; $0,530 \leq y \leq 0,660$;
$0,340 \leq z \leq 0,480$ gezüchtet.

Das fünfwertige Kation von Niob hat gemäß der Tabelle 1 (a) den gleichen Wert von 0,064 nm für den Radius wie das fünfwertige Kation von Tantal, es kann daher in den Mischkristallen anstelle von $Ta^{5+}$ benutzt werden. Entsprechend zur Tantal-Gruppe werden auch in der Niob-Gruppe mehrere Mischkristallreihen mit Verteilungskoeffizienten $k_{eff (kat)}$ von 1 erhalten. Die Mischkristallreihen verschieben sich jedoch zu Seltenerdmetallen mit kleineren Radien. Als Beispiel für die Mischkristallbildung in der Niob-Gruppe sind in Tabelle 3 die Werte für sechs Schmelz- und Kristallzusammensetzungen, die mittleren Ionenradien, die Verteilungskoeffizienten $k_{eff(kat)}$, die Bindungslängen für kubische Perowskite, die Gitterkonstanten sowie die auf die Einheitszelle normierten Gitterkonstanten angegeben.

Mischkristalle, die nach dem vorliegenden Verfahren hergestellt wurden, können als Substrate für die Epitaxie von Hochtemperatursupraleiter-Schichten eingesetzt werden, wobei die Gitterkonstanten der Substrate an die Gitterkonstanten der aufzubringenden Schicht angepaßt werden. Ein Hochtemperatursupraleiter wie z.B. die Verbindung $YBa_2Cu_3O_{7-\delta}$ hat für die Gitterkonstanten die Werte a = 0,3818 nm, b = 0,3886 nm und c = 1,1680 nm. Für das einkristalline Aufwachsen einer solchen Schicht auf einem Substrat ist es notwendig, daß die a- und b- Gitterkonstanten in der Aufwachsebene von Substrat und Schicht sehr nahe beieinander liegen. Die nach dem vorliegenden Verfahren hergestellten Perowskit-Mischkristalle haben eine a-Gitterkonstante (kleinste Gitterkonstante) im Bereich von 0,379 nm bis hin zu 0,387 nm. Für die Anpassung der Substratgitterkonstanten an die Gitterkonstanten der Schicht, z.B. des Supraleiters $YBa_2Cu_3O_{7-\delta}$ mit a = 0,3818 nm und b = 0,3886 nm, wird zunächst ein Mischkristall gezüchtet, dessen a-Gitterkonstante (kleinste Gitterkonstante) über die Kristallzusammensetzung auf den Wert von a = 0,3818 nm eingestellt wird. Anschließend wird der Mischkristall orientiert und danach um die c-Achse gekippt, so daß sich zwischen der b- und b'-Achse ein Winkel von bis zu 100 ergibt (vergleiche Figur 3). Auf diese Weise wird die zweite größere Gitterkonstante, die sich aus der Gleichung

$$b' = \frac{b}{\cos \alpha}$$

ergibt, eingestellt. Der Mischkristall wird anschließend in Scheiben von 0,5 mm Dicke geschnitten und die Scheiben werden poliert. Die auf diese Weise erhaltenen Substratscheiben haben in der Aufwachsebene die Gitterkonstanten a = 0,3818 nm und b' = 0,3886 nm (vergleiche hierzu Figur 3).

Tabelle 1:

| Radien der Kationen | | | | | |
|---|---|---|---|---|---|
| **Kubooktaederplatz** | | | **Oktaederplatz** | | |
| **Kation** | **Radius in nm** | | **Kation** | **Radius in nm** | |
| $Ba^{3+}$ | 1.61 | (a) | $Al^{3+}$ | 0.539 | (b) |
| $Ca^{2+}$ | 1.34 | (a) | $Ga^{3+}$ | 0.610 | (b) |
| $Ce^{3+}$ | 1.34 | (a) | $Hf^{4+}$ | 0.71 | (a) |
| $Dy^{3+}$ | 1.175 | (c) | $In^{3+}$ | 0.792 | (b) |
| $Eu^{3+}$ | 1.226 | (c) | $Mg^{2+}$ | 0.720 | (a) |
| $Gd^{3+}$ | 1.21 | (c) | $Nb^{5+}$ | 0.64 | (a) |
| $K^{1+}$ | 1.64 | (a) | $Ta^{5+}$ | 0.64 | (a) |
| $La^{3+}$ | 1.36 | (a) | $Ti^{4+}$ | 0.582 | (b) |
| $Na^{1+}$ | 1.39 | (a) | $Zr^{4+}$ | 0.745 | (b) |
| $Nd^{3+}$ | 1.29 | (c) | | | |
| $Pr^{3+}$ | 1.30 | (a) | | | |
| $Sm^{3+}$ | 1.24 | (a) | | | |
| $Sr^{2+}$ | 1.44 | (a) | | | |
| $Tb^{3+}$ | 1.19 | (c) | | | |
| $Y^{3+}$ | 1.158 | (c) | | | |

(a) Ionenradien nach Shannon, Acta Cryst. (1976), A 32, Seite 751

(b) Ionenradien nach Strocka et al., PHILIPS J. Res. 33 (1978), Seiten 186-202

(c) Ionenradien berechnet

Tabelle 2:

| Nr. | Schmelz-(I), Kristallzusammensetzung(II), Bindungslängen (A-O) (B-O) in nm(III) und keff(VI) | $[\bar{r}]^{12}$ nm | $[\bar{r}]^{6}$ nm | $a_{O_{ber.}}$ nm | a nm | b nm | c nm | a/2 nm | a/√2 nm |
|---|---|---|---|---|---|---|---|---|---|
| | **Lanthan - Perowskite** | | | | | | | | |
| 1 | (I) La0.290 Sr0.710 Al0.645 Ta0.355 O3 <br> (II) La0.285 Sr0.715 Al0.643 Ta0.357 O3 <br> (III) (0.2737) (0.1935) <br> (IV) 0.98 1.01 1.00 1.01 | 0.14168 | 0.05749 | 0.7740 | 0.7741 | | 0.3871 | | |
| 2 | (I) La0.230 Sr0.100 Ca0.658 Al0.623 Ta0.585 O3 <br> (II) La0.240 Sr0.101 Ca0.650 Al0.621 Ta0.383 O3 <br> (IV) 1.04 1.01 0.99 1.00 0.99 | 0.13444 | 0.05771 | | 0.5412 | 0.5417 | 0.7657 | | 0.3827 |
| 3 | (I) La0.221 Ca0.763 Al0.622 Ta0.389 O3 <br> (II) La0.226 Ca0.769 Al0.619 Ta0.386 O3 <br> (IV) 1.02 1.01 1.00 0.99 | 0.13311 | 0.05772 | | 0.5395 | 0.5400 | 0.7640 | | 0.3815 |
| | **Praseodym - Perowskite** | | | | | | | | |
| 4 | (I) Pr0.380 Sr0.620 Al0.690 Ta0.310 O3 <br> (II) Pr0.382 Sr0.618 Al0.691 Ta0.309 O3 <br> (III) (0.2721) (0.1924) <br> (IV) 1.01 1.00 1.00 1.00 | 0.13868 | 0.05703 | 0.7696 | 0.7698 | | 0.3849 | | |
| 5 | (I)* Pr0.219 Ca0.772 Al0.615 Ta0.391 O3 | 0.13236 | 0.05778 | | | | | | |
| | **Neodym - Perowskite** | | | | | | | | |
| 6 | (I) Nd0.400 Sr0.600 Al0.700 Ta0.300 O3 <br> (II) Nd0.399 Sr0.601 Al0.700 Ta0.300 O3 <br> (III) (0.2718) (0.1922) <br> (IV) 1.00 1.00 1.00 1.00 | 0.13800 | 0.05693 | 0.7687 | 0.7689 | | 0.3845 | | |
| 7 | (I) Nd0.306 Sr0.374 Ca0.317 Al0.655 Ta0.347 O3 <br> (II) Nd0.308 Sr0.372 Ca0.315 Al0.654 Ta0.348 O3 <br> (IV) 1.01 0.99 0.99 1.00 1.00 | 0.13596 | 0.05738 | | 0.5430 | 0.5438 | 0.7683 | | 0.3840 |
| 8 | (I) Nd0.254 Sr0.200 Ca0.540 Al0.631 Ta0.373 O3 <br> (II) Nd0.261 Sr0.196 Ca0.533 Al0.624 Ta0.378 O3 <br> (IV) 1.03 0.98 0.99 0.99 1.01 | 0.13422 | 0.05763 | | 0.5400 | 0.5408 | 0.7644 | | 0.3818 |
| 9 | (I) Nd0.225 Ca0.766 Al0.619 Ta0.387 O3 <br> (II) Nd0.226 Ca0.763 Al0.620 Ta0.386 O3 <br> (IV) 1.00 1.00 1.00 1.00 | 0.13211 | 0.05775 | | 0.5372 | 0.5393 | 0.7607 | | 0.3799 |
| | **Samarium - Perowskite** | | | | | | | | |
| 10 | (I) Sm0.490 Sr0.510 Al0.745 Ta0.255 O3 <br> (II) Sm0.488 Sr0.512 Al0.745 Ta0.255 O3 <br> (III) (0.2701) (0.1910) <br> (IV) 1.00 1.00 1.00 1.00 | 0.13420 | 0.05648 | 0.7640 | 0.3820 | | | | |
| 11 | (I) Sm0.288 Ca0.697 Al0.654 Ta0.356 O3 <br> (II) Sm0.290 Ca0.700 Al0.657 Ta0.352 O3 <br> (IV) 1.01 1.00 1.00 0.99 | 0.12985 | 0.05739 | | 0.5365 | 0.5385 | 0.7580 | | 0.3794 |
| | **Europium - Perowskite** | | | | | | | | |
| 12 | (I)* Eu0.430 Sr0.243 Ca0.315 Al0.723 Ta0.285 O3 | 0.13051 | 0.05670 | | | | | | |
| 13 | (I) Eu0.356 Ca0.626 Al0.690 Ta0.322 O3 <br> (II) Eu0.349 Ca0.631 Al0.692 Ta0.323 O3 <br> (IV) 0.98 1.01 1.00 1.00 | 0.12842 | 0.05703 | | 0.5357 | 0.5369 | 0.7550 | | 0.3788 |

\* Zusammensetzungen berechnet

Tabelle 3:

| Nr. | Schmelz-(I), Kristallzusammensetzung(II), Bindungslängen (A-O) (B-O) in nm(III) und keff(VI) | $[\bar{r}]^{12}$ nm | $[\bar{r}]^{6}$ nm | Gitterkonstanten | | | | | |
|---|---|---|---|---|---|---|---|---|---|
| | | | | $a_{0_{ber.}}$ nm | a nm | b nm | c nm | a/2 nm | a/√2 nm |
| | **Lanthan - Perowskit** | | | | | | | | |
| 14 | (I) La0.030  Ca0.960 Al0.530 Nb0.480 O3 <br> (II) La0.035  Ca0.955 Al0.529 Nb0.481 O3 <br> (IV) 1.17   0.99   1.00   1.00 | 0.13346 | 0.05865 | | 0.5384 | 0.5416 | 0.7628 | | 0.3807 |
| | **Neodym - Perowskit** | | | | | | | | |
| 15 | (I) Nd0.190 Sr0.810    Al0.595 Nb0.405 O3 <br> (II) Nd0.192 Sr0.808   Al0.597 Nb0.403 O3 <br> (III) 1.01  1.00    1.00  1.00 <br> (IV) (0.2739)    (0.1936) | 0.14115 | 0.5799 | 0.3873 | 0.3872 | | | | |
| | **Samarium - Perowskit** | | | | | | | | |
| 16 | (I) Sm0.320 Sr0.680    Al0.660 Nb0.340 O3 <br> (II) Sm0.315 Sr0.685   Al0.658 Nb0.342 O3 <br> (III) (0.2719)    (0.1923) <br> (IV) 0.98  1.01    1.00  1.01 | 0.13760 | 0.05733 | 0.3845 | 0.3847 | | | | |
| | **Gadolinium - Perowskite** | | | | | | | | |
| 17 | (I) Gd0.075  Ca0.910 Al0.560 Nb0.455 O3 <br> (II) Gd0.080  Ca0.900 Al0.565 Nb0.455 O3 <br> (IV) 1.07   0.99   1.01   1.00 | 0.13213 | 0.05834 | | 0.5365 | 0.5407 | 0.7609 | | 0.3794 |
| 18 | (I) Gd0.116 Sr0.206 Ca0.670 Al0.570 Nb0.438 O3 <br> (II) Gd0.115 Sr0.204 Ca0.670 Al0.573 Nb0.438 O3 <br> (IV) 0.99  0.99  1.00  1.01  1.00 | 0.13407 | 0.05824 | | 0.5382 | 0.5403 | 0.7619 | | 0.3806 |
| | **Yttrium - Perowskit** | | | | | | | | |
| 19 | (I) Y0.290  Ca0.700 Al0.660 Nb0.350 O3 <br> (II) Y0.285  Ca0.705 Al0.658 Nb0.352 O3 <br> (IV) 0.98   1.01   1.00   1.01 | 0.12812 | 0.05733 | | 0.5358 | 0.5400 | 0.7597 | | 0.3789 |

**Patentansprüche**

1. Verfahren zur Züchtung von Mischkristallen mit zwei Gitterplätzen mit jeweils einer unterschiedlichen Anzahl benachbarter Sauerstoffionen aus Schmelzen oxidischer Vielstoffsysteme, dadurch gekennzeichnet,

   daß homogene Mischkristalle gezüchtet werden, derart, daß die Kationen für die Besetzung des ersten Gitterplatzes mit der höchsten Anzahl benachbarter Sauerstoffionen und für die Besetzung des zweiten Gitterplatzes mit der nächst niedrigeren Anzahl benachbarter Sauerstoffionen so ausgewählt werden, daß das Verhältnis der mittleren Ionenradien der Kationen auf dem ersten Gitterplatz zu den mittleren Ionenradien der Kationen auf dem zweiten Gitterplatz im Bereich von 2,2 bis 2,5 liegt.

2. Verfahren nach Anspruch 1, dadurch gekennzeichnet,
   daß die Kationen für die Besetzung des ersten Gitterplatzes und für die Besetzung des zweiten Gitterplatzes so ausgewählt werden, daß das Verhältnis der mittleren Ionenradien der Kationen auf dem ersten Gitterplatz zu den mittleren Ionenradien der Kationen auf dem zweiten Gitterplatz im Bereich von 2,23 bis 2,46 liegt.

3. Verfahren zur Züchtung von Mischkristallen auf Basis von Seltenerdmetall/Aluminium-Perowskit nach den Ansprüchen 1 und 2, dadurch gekennzeichnet,
daß die Zusammensetzung der die Schmelze bildenden Komponenten zur Züchtung homogener Mischkristalle in Abhängigkeit jeweils der mittleren Ionenradien der Kationen des Kubooktaederplatzes (Koordinationszahl = 12) und die Kationen des Oktaederplatzes (Koordinationszahl = 6) so ausgewählt wird, daß die mittleren Ionenradien der Kationen des Kubooktaederplatzes im Bereich von 0,14168 nm bis 0,12842 nm und die mittleren Ionenradien der Kationen des Oktaederplatzes im Bereich von 0,05865 nm bis 0,05648 nm liegen.

4. Verfahren nach mindestens einem der Ansprüche 1 bis 3,
dadurch gekennzeichnet,
daß Mischkristalle gezüchtet werden mit einer Zusammensetzung gemäß der allgemeinen Formel:
$RE_wA_xAl_yB_zO_3$, worin sind

$RE =$  1 Kation aus der Gruppe $La^{3+}$, $Pr^{3+}$, $Ce^{3+}$, $Nd^{3+}$, $Sm^{3+}$, $Eu^{3+}$, $Gd^{3+}$, $Tb^{3+}$, $Dy^{3+}$, $Ho^{3+}$, $Y^{3+}$;

$A =$  $Ca^{2+}$ und/oder $Sr^{2+}$

$B =$  $Ta^{5+}$ und/oder $Nb^{5+}$ und $0,030 \leq w \leq 0,490$
$0,510 \leq x \leq 0,960$
$0,530 \leq y \leq 0,745$
$0,255 \leq z \leq 0,480$.

5. Verfahren nach Anspruch 4,
dadurch gekennzeichnet,
daß Mischkristalle gezüchtet werden mit einer Zusammensetzung gemäß der allgemeinen Formel:
$RE_wA_xAl_yTa_zO_3$, worin sind
$RE =$  1 Kation aus der Gruppe $Eu^{3+}$, $Sm^{3+}$, $Nd^{3+}$, $Pr^{3+}$, $La^{3+}$;
$A =$  $Ca^{2+}$ und/oder $Sr^{2+}$ und $0,219 \leq w \leq 0,490$
$0,510 \leq x \leq 0,772$
$0,615 \leq y \leq 0,745$
$0,255 \leq z \leq 0,391$.

6. Verfahren nach Anspruch 5,
dadurch gekennzeichnet,
daß die Zusammensetzung der Mischkristalle in einer Mischkristallreihe liegt mit Zusammensetzung gemäß der allgemeinen Formel:
$La_xCa_xSr_vAl_yTa_zO_3$, worin sind
$0 \leq v \leq 0,710$
$0,221 \leq w \leq 0,290$
$0 \leq x \leq 0,763$
$0,622 \leq y \leq 0,645$
$0,355 \leq z \leq 0,389$.

7. Verfahren nach Anspruch 6,
dadurch gekennzeichnet,
daß das Anfangsglied der Mischkristallreihe die Schmelzzusammensetzung hat
$La_{0,221}Ca_{0,763}Al_{0,622}Ta_{0,389}O_3$
und daß das Endglied der Mischkristallreihe die Schmelzzusammensetzung hat
$La_{0,290}Sr_{0,710}Al_{0,645}Ta_{0,355}O_3$.

8. Verfahren nach Anspruch 5,
dadurch gekennzeichnet,
daß die Zusammensetzung der Mischkristalle in einer Mischkristallreihe liegt mit Zusammensetzung gemäß der allgemeinen Formel:
$Pr_wCa_xSr_vAl_yTa_zO_3$, worin sind

11

$0 \leq v \leq 0{,}620$

$0{,}219 \leq w \leq 0{,}380$

$0 \leq x \leq 0{,}772$

$0{,}615 \leq y \leq 0{,}690$

$0{,}310 \leq z \leq 0{,}391.$

9. Verfahren nach Anspruch 8,
   dadurch gekennzeichnet,
   daß das Anfangsglied der Mischkristallreihe die Schmelzzusammensetzung hat:
   $Pr_{0,219}Ca_{0,772}Al_{0,615}Ta_{0,391}O_3$
   und daß das Endglied der Mischkristallreihe die Schmelzzusammensetzung hat
   $Pr_{0,38}Sr_{0,62}Al_{0,69}Ta_{0,31}O_3.$

10. Verfahren nach Anspruch 5,
    dadurch gekennzeichnet,
    daß die Zusammensetzung der Mischkristalle in einer Mischkristallreihe liegt mit Zusammensetzung gemäß der allgemeinen Formel
    $Nd_wCa_xSr_vAl_yTa_zO_3$, worin sind
    $0 \leq v \leq 0{,}600$
    $0{,}225 \leq w \leq 0{,}400$
    $0 \leq x \leq 0{,}766$
    $0{,}619 \leq y \leq 0{,}700$
    $0{,}300 \leq z \leq 0{,}387.$

11. Verfahren nach Anspruch 10,
    dadurch gekennzeichnet,
    daß das Anfangsglied der Mischkristallreihe die Schmelzzusammensetzung hat
    $Nd_{0,255}Ca_{0,766}Al_{0,619}Ta_{0,387}O_3$
    und daß das Endglied der Mischkristallreihe die Schmelzzusammensetzung hat
    $Nd_{0,40}Sr_{0,60}Al_{0,70}Ta_{0,30}O_3.$

12. Verfahren nach Anspruch 5,
    dadurch gekennzeichnet,
    daß die Zusammensetzung der Mischkristalle in einer Mischkristallreihe liegt mit einer Zusammensetzung gemäß der allgemeinen Formel:
    $Sm_wCa_xSr_vAl_yTa_zO_3$, worin sind
    $0 \leq v \leq 0{,}510$
    $0{,}288 \leq w \leq 0{,}490$
    $0 \leq x \leq 0{,}697$
    $0{,}654 \leq y \leq 0{,}745$
    $0{,}255 \leq z \leq 0{,}356.$

13. Verfahren nach Anspruch 12,
    dadurch gekennzeichnet,
    daß das Anfangsglied der Mischkristallreihe die Schmelzzusammensetzung hat
    $Sm_{0,288}Ca_{0,697}Al_{0,654}Ta_{0,356}O_3$
    und daß das Endglied der Mischkristallreihe die Schmelzzusammensetzung hat
    $Sm_{0,49}Sr_{0,51}Al_{0,745}Ta_{0,255}O_3.$

14. Verfahren nach Anspruch 5,
    dadurch gekennzeichnet,
    daß die Zusammensetzung der Mischkristalle in einer Mischkristallreihe liegt mit Zusammensetzung gemäß der allgemeinen Formel:
    $Eu_wCa_xSr_vAl_yTa_zO_3$, worin sind
    $0 \leq v \leq 0{,}243$
    $0{,}356 \leq w \leq 0{,}430$
    $0{,}315 \leq x \leq 0{,}626$
    $0{,}690 \leq y \leq 0{,}723$

$0{,}285 \leq z \leq 0{,}322$.

15. Verfahren nach Anspruch 14,
dadurch gekennzeichnet,
daß das Anfangsglied der Mischkristallreihe die Schmelzzusammensetzung hat
$Eu_{0,356}Ca_{0,626}Al_{0,69}Ta_{0,322}O_3$
und daß das Endglied der Mischkristallreihe die Schmelzzusammensetzung hat
$Eu_{0,43}Ca_{0,315}Sr_{0,243}Al_{0,723}Ta_{0,285}O_3$.

16. Verfahren nach Anspruch 4,
dadurch gekennzeichnet,
daß Mischkristalle gezüchtet werden mit einer Zusammensetzung gemäß der allgemeinen Formel:
$RE_wA_xAl_yNb_zO_3$, worin sind
$RE =$ 1 Kation aus der Gruppe $Y^{3+}$, $Ho^{3+}$, $Dy^{3+}$, $Tb^{3+}$, $Gd^{3+}$, $Sm^{3+}$, $Nd^{3+}$, $Pr^{3+}$, $La^{3+}$;
$A =$ $Ca^{2+}$ und/oder $Sr^{2+}$ und $0{,}030 \leq w \leq 0{,}320$
$0{,}680 \leq x \leq 0{,}960$
$0{,}530 \leq y \leq 0{,}660$
$0{,}340 \leq z \leq 0{,}480$.

17. Verwendung der nach dem Verfahren gemäß den Ansprüchen 1 bis 16 hergestellten Mischkristalle für die Herstellung monokristalliner Schichten auf Substraten.

18. Verwendung der nach dem Verfahren gemäß den Ansprüchen 1 bis 16 hergestellten Mischkristalle für die Herstellung von auf einem Substrat angebrachten Vielschichtstrukturen aus unterschiedlichen monokristallinen Schichten einer Dicke von jeweils > 100 x a, wobei a die Gitterkonstante des Materials der jeweiligen Schicht ist.

19. Verwendung der nach dem Verfahren gemäß den Ansprüchen 1 bis 16 hergestellten Mischkristalle für die Herstellung von auf einem Substrat angebrachten Vielschichtstrukturen aus unterschiedlichen monokristallinen Schichten einer Dicke von jeweils < 100 x a, wobei a die Gitterkonstante des Materials der jeweiligen Schicht ist.

20. Verwendung der nach dem Verfahren gemäß den Ansprüchen 1 bis 16 hergestellten Mischkristalle für die Herstellung von monokristallinen Substraten mit gewünschten Gitterkonstanten.

FIG.1

$$RE_w\ A_x\ Al_y\ Ta_z\ O_3$$

RE=Seltenerdmetall
A = Ca 2+ und/oder Sr 2+

$0.379nm \leq a \geq 0.387nm$

FIG.2

$b' = \dfrac{b}{cos\alpha} = 0.3886\,nm$

$a = 0.3818\,nm$

FIG.3